# EUROPEAN PATENT APPLICATION

(11) **EP 4 414 401 A1**
(43) Date of publication of application: **14.08.2024**
(21) Application number: 22878424.5
(22) Date of filing: 29.09.2022
(51) Int. Cl.: C08G 59/02

(54) **EPOXY RESIN PRODUCTION METHOD, EPOXY RESIN COMPOSITION, CURED PRODUCT, AND ELECTRIC/ELECTRONIC COMPONENT**

(30) Priority: 04.10.2021 JP 2021163584
(71) Applicant: Mitsubishi Chemical Corporation, Chiyoda-ku Tokyo 100-8251 (JP)
(72) Inventor: URANO, Wataru, Tokyo 100-8251 (JP)
(74) Representative: TBK
(86) International application number: PCT/JP2022/036481
(87) International publication number: WO 2023/058554

(57) **Abstract**

A method for producing an epoxy resin, including reacting a raw material phenol compound or a raw material amine compound and epihalohydrin, wherein said reaction is performed in the presence of a compound represented by the following formula (1): 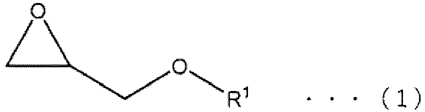 in the formula (1), R¹ represents an aliphatic hydrocarbon group having 1 to 8 carbon atoms.

## Description

### TECHNICAL FIELD

The present invention relates to a method for producing an epoxy resin, and more specifically an industrially advantageous method for producing an epoxy resin, and an epoxy resin or an epoxy resin composition each obtained by the production method, as well as a cured product and an electric/electronic component each obtained by curing the epoxy resin composition.

### BACKGROUND ART

Epoxy resins are cured with various curing agents and thus formed into cured products generally excellent in mechanical properties, heat resistance, electric properties, and the like, and therefore are utilized in a wide range of fields such as adhesives, paint, and electric/electronic materials. In particular, tetramethylbiphenol type epoxy resins are heavily used in the semiconductor sealant application among electric/electronic material fields, because of being capable of providing sealants of high value.

The following (1), (2), and (3) have been required as recent semiconductor sealant production technology trends.

### (1) Reduction in cost by rationalization of production process of semiconductor sealant

There are demands not only enhancements in quality and productivity of a production process of an epoxy resin serving as a raw material, but also quality of a cured product itself such as a semiconductor sealant, which is obtained by mixing an epoxy resin and a curing agent, and rationalization of a curing process.

### (2) Adaptation to semiconductor manufacturing under high-temperature environment

A cured product obtainable by mixing an epoxy resin used as a raw material of a semiconductor sealant, with a curing agent and curing them, is needed to be excellent in heat-resistant durability in consideration of manufacturing under a high-temperature environment.

### (3) High reliability of semiconductor sealant in long-term use

A cured product obtainable by mixing an epoxy resin used as a raw material of a semiconductor sealant, with a curing agent and curing them, is needed to be excellent in electric reliability in consideration of long-term use.

Patent Document 1 describes production of a tetramethylbiphenol type epoxy resin by reacting 4,4'-bishydroxy-3,3',5,5'-tetramethylbiphenyl and epichlorohydrin.

### PRIOR ART DOCUMENTS

### PATENT DOCUMENTS

[Patent Document 1] Japanese Unexamined Patent Publication No. S58-039677

### SUMMARY OF THE INVENTION

### PROBLEMS TO BE SOLVED BY THE INVENTION

While semiconductors have been conventionally manufactured by high-temperature forming processes capable of manufacturing at short times for enhancement of productivity, there have been recently developed semiconductor manufacturing processes involving forming at lower temperatures for the purpose of reduction of load on the environment. On the other hand, high-temperature forming processes are adopted in some manufacturing processes such as reflow steps, in terms of properties of materials, and a problem is that thermal cracking occurs due to water absorption of materials during forming at high temperatures. According to such semiconductor manufacturing process trends, there is a demand for a semiconductor material which can be formed at a lower temperature and which has high heat-resistant durability when formed, and there is a demand for, as a semiconductor sealant, a low water-absorption material which flows at a lower temperature than conventional one and which has high durability against a manufacturing process at a high temperature.

Semiconductors have been increasingly demanded to have high electric reliability so as to withstand long-term use from the viewpoints of enhancement of safety of self-driving technologies and increase of lifetime of electronic devices. According to such semiconductor technology trends, there is a demand for a semiconductor material lower in water absorption and higher in electric reliability, and there is a demand for, as a semiconductor sealant, a low water-absorption material which can be expected to have electric high reliability in long-term use as compared with conventional one.

The epoxy resin described in Patent Document 1 has not been sufficiently satisfactory in terms of the speed of melt mixing of the epoxy resin with other component, in which the speed is important for productivity in a production process of a semiconductor sealant, the process including producing the epoxy resin on an industrial scale and forming a cured product with the epoxy resin.

A cured product obtained with the epoxy resin described in Patent Document 1 has not sufficiently satisfied heat-resistant durability at a high temperature because, when the cured product is produced as a semiconductor sealant at a high temperature, cracking sometimes occurs on the sealant.

A cured product obtained with the epoxy resin described in Patent Document 1 has not satisfied electric reliability because, when the cured product is used as a semiconductor sealant for a long period, electric failures such as corrosion of wiring sometimes occur due to water absorption with the sealant.

An object of the present invention is to provide an epoxy resin composition and a method for producing the epoxy resin composition, as well as a cured product and an electric/electronic component of the epoxy resin composition, in which productivity in epoxy resin production is high, flowing is made at a lower temperature in semiconductor manufacturing, industrial handleability is high, resistance to a forming process at a high temperature is high, and water absorption properties are low and electric reliability is high in the form of a semiconductor sealant,.

### MEANS FOR SOLVING THE PROBLEMS

The present inventor has made intensive studies in order to solve the above problems, and as a result, has found that the above problems can be solved by an epoxy resin obtained by allowing a compound having a specified ether structure to be present during production of the epoxy resin by reaction of a phenol compound or an amine compound and epihalohydrin as raw materials, thereby leading to completion of the present invention.

Specifically, the gist of the present invention consists in the following [1] to [10].
[1] A method for producing an epoxy resin, comprising reacting a raw material phenol compound or a raw material amine compound and epihalohydrin, wherein said reaction is performed in the presence of a compound represented by the following formula (1). 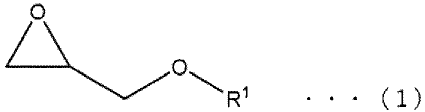 In the formula (1), R¹ represents an aliphatic hydrocarbon group having 2 to 8 carbon atoms.
[2] The method for producing an epoxy resin according to [1], wherein an amount of the compound represented by the formula (1) is 0.01 to 19% by mass relative to the epihalohydrin.
[3] The method for producing an epoxy resin according to [1] or [2], wherein the raw material phenol compound is represented by the following formula (2), and the epoxy resin comprises an epoxy compound represented by the following formula (3). 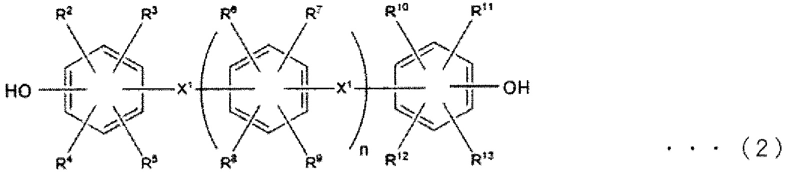 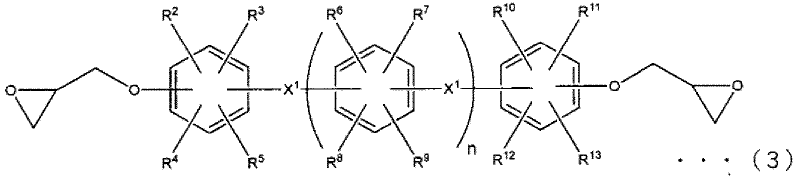 In the formulae (2) and (3), X¹ is a group selected from the group consisting of a divalent hydrocarbon group having 1 to 13 carbon atoms, -O-, -S-, -SO₂-, -C(CF₃)₂- and -CO-, or a direct bond, R² to R¹³ are each independently a hydrogen atom, an alkyl group having 1 to 12 carbon atoms, an alkoxy group having 1 to 12 carbon atoms, an aryl group having 6 to 12 carbon atoms, an alkenyl group having 2 to 12 carbon atoms or an alkynyl group having 2 to 12 carbon atoms, and n represents an integer of 0 to 10.
[4] The method for producing an epoxy resin according to any of [1] to [3], wherein the epoxy resin comprises an epoxy compound represented by the following formula (4). 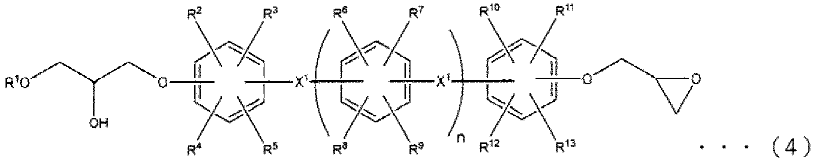 In the formula (4), X¹, R² to R¹³, and n have the same meanings as those in the formula (2) and the formula (3), and R¹ has the same meaning as that in the formula (1).
[5] An epoxy resin composition (A) comprising 80.0 to 99.9% by mass of an epoxy compound represented by the following formula (3) and comprising 0.1 to 8.0% by mass of an epoxy compound represented by the following formula (5). 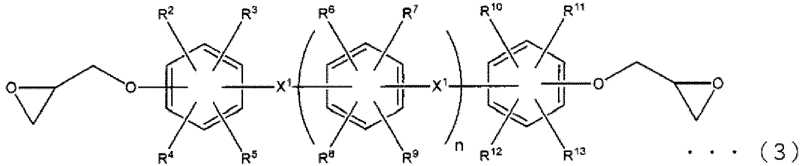 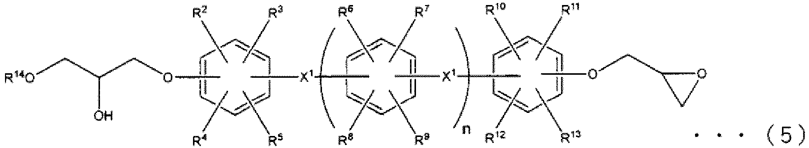 In the formulae (3) and (5), X¹ is a group selected from the group consisting of a divalent hydrocarbon group having 1 to 13 carbon atoms, -O-, -S-, -SO₂-, -C(CF₃)₂- and -CO-, or a direct bond, R² to R¹³ are each independently a hydrogen atom, an alkyl group having 1 to 12 carbon atoms, an alkoxy group having 1 to 12 carbon atoms, an aryl group having 6 to 12 carbon atoms, an alkenyl group having 2 to 12 carbon atoms or an alkynyl group having 2 to 12 carbon atoms, and n represents an integer of 0 to 10.
   R¹⁴ is a non-linear aliphatic hydrocarbon group having 3 to 8 carbon atoms.
[6] The epoxy resin composition (A) according to [5], wherein an amount of hydrolyzable chlorine is 1000 ppm by mass or less.
[7] An epoxy resin composition (B) comprising the epoxy resin composition (A) according to [5] or [6] and comprising 0.01 to 1000 parts by mass of a curing agent based on 100 parts by mass of the epoxy resin composition (A).
[8] The epoxy resin composition (B) according to [7], wherein the curing agent is at least one selected from the group consisting of a phenol-based curing agent, an amine-based curing agent, an acid anhydride-based curing agent, and an amide-based curing agent.
[9] A cured product obtainable by curing the epoxy resin composition (B) according to [7] or [8].
[10] An electric/electronic component obtained by curing the epoxy resin composition (B) according to [7] or [8].

### EFFECTS OF THE INVENTION

An epoxy resin obtained by the present invention has a low melting point and also has excellent fluidity at a low temperature, and thus is expected to flow at a lower temperature in semiconductor manufacturing and be increased in industrial handleability in a semiconductor manufacturing process.

An epoxy resin obtained by the method for producing an epoxy resin of the present invention and/or a cured product in which the epoxy resin composition of the present invention is used have/has low water absorption and a small amount of chlorine contained, and thus not only have/has excellent long-term electric reliability, but also have/has low water absorption, have/has excellent heat-resistant durability in a high-temperature environment in semiconductor manufacturing, can have a low elastic modulus to provide relaxation of stress due to the change in temperature, and can be suitably used in a semiconductor sealant or the like.

### DESCRIPTION OF EMBODIMENTS

Hereinafter, embodiments of the present invention are described in detail. The following description provides one example of embodiments of the present invention, and the present invention is not limited to the following description without departing from the gist thereof.

The expression "to", as used herein, is used as an expression including numerical values or physical property values before and after "to".

The epoxy resin in the present embodiment encompasses one containing a repeating structure and one having a monomolecular structure, and both these epoxy compounds may be expressed and sold as "epoxy resin" or "epoxy resin composition" in the art. A mixture further including a different epoxy resin from the epoxy resin in the present embodiment may also be expressed as "epoxy resin composition" or simply referred to as "epoxy resin" in the art.

### [Method for producing epoxy resin]

A method for producing an epoxy resin according to a first embodiment of the present invention includes reacting a raw material phenol compound or a raw material amine compound and epihalohydrin in the presence of a compound represented by the following formula (1) (hereinafter, sometimes referred to as "compound (1)".) in production of the epoxy resin by the reaction.

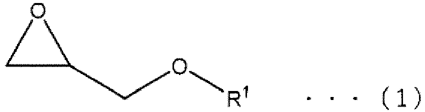

In the formula (1), R¹ represents an aliphatic hydrocarbon group having 2 to 8 carbon atoms.

An epoxy resin produced by the method for producing an epoxy resin of the present embodiment preferably includes an epoxy compound represented by the following formula (3) (hereinafter, sometimes referred to as "epoxy compound (3)" or "epoxy resin (3)".), and preferably includes the epoxy compound (3) and an epoxy compound represented by the following formula (4) (hereinafter, sometimes referred to as "epoxy compound (4)" or "epoxy resin (4)".).

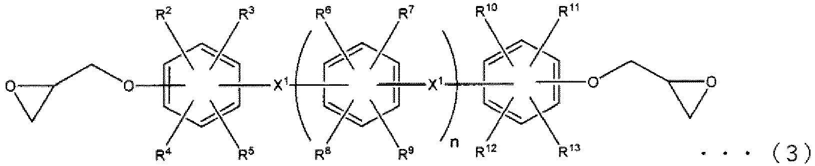

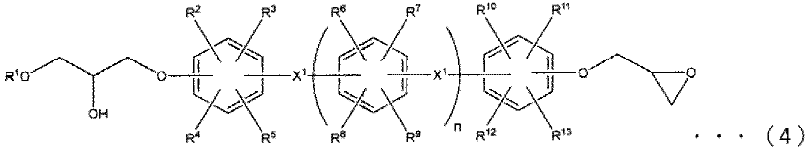

In the formulae (3) and (4), R² to R¹³, X¹, and n have the same meanings as those in formula (2) described below. Herein, the same also applies to preferred R² to R¹³, X¹, and n.

The phenol compound, the amine compound, the compound (1), and the epihalohydrin used in the present embodiment can be each an industrially available commercial product.

The phenol compound is not particularly limited as long as it is a compound having a phenol backbone, and is preferably represented by the following formula (2).

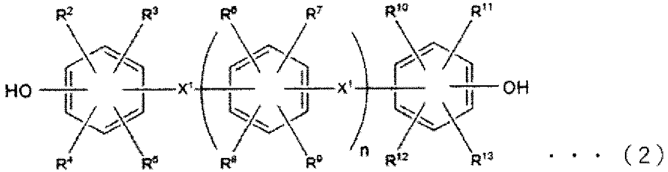

In the formula (2), X¹ is a divalent linking group, and is a group selected from the group consisting of a divalent hydrocarbon group having 1 to 13 carbon atoms, -O-, -S-, -SO₂-, -C(CF₃)₂- and -CO-, or a direct bond, R² to R¹³ are each independently a hydrogen atom, an alkyl group having 1 to 12 carbon atoms, an alkoxy group having 1 to 12 carbon atoms, an aryl group having 6 to 12 carbon atoms, an alkenyl group having 2 to 12 carbon atoms or an alkynyl group having 2 to 12 carbon atoms, and n represents an integer of 0 to 10.

X¹ is preferably a direct bond, or a divalent hydrocarbon group having 1 to 13 carbon atoms. Examples of the divalent hydrocarbon group having 1 to 13 carbon atoms preferably include an aliphatic hydrocarbon group having 1 to 10 carbon atoms, particularly preferably an alkylene group optionally having a branch having 1 to 10 carbon atoms. X¹ is more preferably a direct bond, a methylene group, or an isopropylidene group, most preferably a direct bond.

In a case where a plurality of X¹'s is present in the formula (2), such X¹'s may be the same as or different from each other.

R² to R¹³ are each independently a hydrogen atom, an alkyl group having 1 to 12 carbon atoms, an alkoxy group having 1 to 12 carbon atoms, an aryl group having 6 to 12 carbon atoms, an alkenyl group having 2 to 12 carbon atoms or an alkynyl group having 2 to 12 carbon atoms, and the alkyl group, the alkoxy group, the aryl group, the alkenyl group, and the alkynyl group each optionally have a substituent.

Examples of the alkyl group include the following.

Examples include a methyl group, an ethyl group, a n-propyl group, an isopropyl group, a n-butyl group, a sec-butyl group, a tert-butyl group, a n-pentyl group, an isopentyl group, a neopentyl group, a tert-pentyl group, a cyclopentyl group, a n-hexyl group, an isohexyl group, a cyclohexyl group, a n-heptyl group, a cycloheptyl group, a methylcyclohexyl group, a n-octyl group, a cyclooctyl group, a n-nonyl group, a 3,3,5-trimethylcyclohexyl group, a n-decyl group, a cyclodecyl group, a n-undecyl group, a n-dodecyl group, a cyclododecyl group, a benzyl group, a methylbenzyl group, a dimethylbenzyl group, a trimethylbenzyl group, a naphthylmethyl group, a phenethyl group, and a 2-phenylisopropyl group.

Examples of the alkoxy group include the following.

Examples include a methoxy group, an ethoxy group, a n-propoxy group, an isopropoxy group, a n-butoxy group, a sec-butoxy group, a tert-butoxy group, a n-pentoxy group, an isopentoxy group, a neopentoxy group, a tert-pentoxy group, a cyclopentoxy group, a n-hexyloxy group, an isohexyloxy group, a cyclohexyloxy group, a n-heptoxy group, a cycloheptoxy group, a methylcyclohexyloxy group, a n-octyloxy group, a cyclooctyloxy group, a n-nonyloxy group, a 3,3,5-trimethylcyclohexyloxy group, a n-decyloxy group, a cyclodecyloxy group, a n-undecyloxy group, a n-dodecyloxy group, a cyclododecyloxy group, a benzyloxy group, a methylbenzyloxy group, a dimethylbenzyloxy group, a trimethylbenzyloxy group, a naphthylmethoxy group, a phenethyloxy group, and a 2-phenylisopropoxy group.

Examples of the alkenyl group include the following.

Examples include a vinyl group, a 1-propenyl group, a 2-propenyl group, a 1-methylvinyl group, a 1-butenyl group, a 2-butenyl group, a 3-butenyl group, a 1,3-butadienyl group, a cyclohexenyl group, a cyclohexadienyl group, a cinnamyl group, and a naphthylvinyl group.

Examples of the alkynyl group include the following.

Examples include an ethynyl group, a 1-propinyl group, a 2-propinyl group, a 1-butynyl group, a 2-butynyl group, a 3-butynyl group, a 1,3-butanedienyl group, a phenylethynyl group, and a naphthylethynyl group.

Examples of the aryl group include a phenyl group, an o-tolyl group, a m-tolyl group, a p-tolyl group, an ethylphenyl group, a styryl group, a xylyl group, a n-propylphenyl group, an isopropylphenyl group, a mesityl group, an ethynylphenyl group, a naphthyl group, and a vinylnaphthyl group.

R² to R¹³ are preferably each independently a hydrogen atom, an alkyl group having 1 to 12 carbon atoms or an aryl group having 6 to 12 carbon atoms, more preferably each independently a hydrogen atom or an alkyl group having 1 to 12 carbon atoms.

In the formula (2), n is an integer of 0 to 10, preferably 0 to 5, more preferably 0 to 3.

Specific examples of the raw material phenol compound include various polyhydric phenols, for example, bisphenol compounds such as bisphenol A, bisphenol F, bisphenol S, bisphenol AD and bisphenol AF, biphenol compounds such as biphenol and tetramethylbiphenol, dihydroxydiphenyl ether, thiodiphenols, a phenol novolac resin, a cresol novolac resin, a phenol aralkyl resin, a biphenyl aralkyl resin, a naphthol aralkyl resin, a terpene phenol resin, a dicyclopentadiene phenol resin, a bisphenol A novolac resin, a naphthol novolac resin, brominated bisphenol A, and a brominated phenol novolac resin, and various phenol resins, for example, polyhydric phenol resins obtained by condensation reaction of various phenols and various aldehydes such as benzaldehyde and crotonaldehyde, and polyhydric phenol resins obtained by condensation reaction of a xylene resin and phenols, preferably bisphenol compounds or biphenol compounds, more preferably biphenol compounds, and particularly preferably tetramethylbiphenol.

The raw material amine compound is not particularly limited as long as it is a compound having an amine backbone, and examples include p-aminophenol, m-aminophenol, o-aminophenol, diaminodiphenylmethane, diethylenetriamine, triethylenetetramine, diaminodiphenylsulfone, isophoronediamine, imidazole, a BF3-amine complex, and a guanidine derivative.

The substituent R¹ of the formula (1) representing the compound (1) is an aliphatic hydrocarbon group having 2 to 8 carbon atoms.

R¹ is not particularly limited in terms of the structure thereof as long as it is an aliphatic hydrocarbon group having 2 to 8 carbon atoms, and the structure may be a non-linear structure such as a branched structure or a cyclic structure. The aliphatic hydrocarbon group having 2 to 8 carbon atoms, as R¹, optionally has a substituent such as a phenyl group or an alkoxy group.

The linear aliphatic hydrocarbon group is preferably a linear alkyl group having 2 to 8 carbon atoms. Specific examples include an ethyl group, a n-propyl group, a n-butyl group, a n-pentyl group, a n-hexyl group, a n-heptyl group, and a n-octyl group, and a linear alkyl group having 2 to 4 carbon atoms is preferred and specific examples thereof include an ethyl group, a n-propyl group, and a n-butyl group.

In the case of a non-linear structure such as a branched structure or a cyclic structure, a non-linear aliphatic hydrocarbon group having 3 to 8 carbon atoms is preferred. Specific examples include an isopropyl group, a 1-methoxy-2-propyl group, a sec-butyl group, a tert-butyl group, an isopentyl group, a neopentyl group, a tert-pentyl group, a cyclopentyl group, an isohexyl group, a cyclohexyl group, a cycloheptyl group, a methylcyclohexyl group, a cyclooctyl group, a benzyl group, and a methylbenzyl group, and an alkyl group having a branched structure and having 3 to 8 carbon atoms is more preferred and specific examples thereof include an isopropyl group, a 1-methoxy-2-propyl group, a sec-butyl group, a tert-butyl group, an isopentyl group, a neopentyl group, and a tert-pentyl group. Such a branched chain optionally has an alkoxy group as a substituent to have an oxygen atom.

The proportion of use of the compound (1) is preferably 0.01 to 19% by mass, more preferably 0.1 to 12% by mass, still more preferably 1.0 to 8.0% by mass relative to epihalohydrin as a raw material. There is a tendency that, as the proportion of use is higher, the resulting epoxy resin has a lower melting point and has a higher fluidity at a low temperature. There is also a tendency that, as the proportion of use is lower, the crystallization time is shorter and productivity is enhanced.

The epihalohydrin is not particularly limited and examples thereof include epichlorohydrin, epibromohydrin, and β-methylepichlorohydrin. In particular, epichlorohydrin is preferred because of being industrially easily available.

In a case where a phenol compound is used as a raw material, 1 to 10 mol of the epihalohydrin is preferably used based on 1 mol of a hydroxyl group contained in the phenol compound as a raw material, and furthermore examples of a preferred method include a method in which reaction is made at a temperature of 20 to 120°C for 0.5 to 10 hours with single addition or gradual addition of 0.9 to 2.0 mol of an alkaline catalyst based on 1 mol of a hydroxyl group contained in the phenol compound as a raw material. The alkaline catalyst may be used in the form of a solid or an aqueous solution thereof, and in a case where the aqueous solution is used, a method may also be adopted in which, while the aqueous solution is continuously added, water and the epihalohydrin are continuously distilled off from a reaction mixture under reduced pressure or under ordinary pressure, and furthermore liquid separation is made to remove water and continuously return the epihalohydrin to the reaction mixture.

In a case where an amine compound is used as a raw material, 2 to 20 mol of the epihalohydrin is preferably used based on 1 mol of an amino group contained in the amine compound as a raw material, and furthermore examples of a preferred method include a method in which reaction is made at a temperature of 20 to 120°C for 0.5 to 10 hours with single addition or gradual addition of 1.8 to 4.0 mol of an alkaline catalyst based on 1 mol of an amino group of the raw material. The alkaline catalyst may be used in the form of a solid or an aqueous solution thereof, and in a case where the aqueous solution is used, a method may also be adopted in which, while the aqueous solution is continuously added, water and the epihalohydrin are continuously distilled off from a reaction mixture under reduced pressure or under ordinary pressure, and furthermore liquid separation is made to remove water and continuously return the epihalohydrin to the reaction mixture.

In a case where epoxy resin production is industrially made, all of epihalohydrin used for loading is fresh in the first batch, and it is preferable in the next and subsequent batches to use epihalohydrin recovered from a crude reaction product and fresh epihalohydrin corresponding to that consumed in the reaction, in combination.

The reaction temperature is preferably in the range of 20 to 90°C and the reaction time is preferably in the range of 0.5 to 10 hours from the viewpoint that the content rate of the epoxy compound (3) in the epoxy resin in the present embodiment is adjusted in a suitable range.

Specific examples of the alkaline catalyst include alkaline earth metal hydroxide, alkali metal carbonate and alkali metal hydroxide. The alkali metal hydroxide is preferred particularly from the viewpoint of being excellent in catalyst activity of epoxy resin synthesis reaction, and examples thereof include sodium hydroxide and potassium hydroxide. The alkaline catalyst, when used, may be used in the form of an aqueous solution of about 10 to 55% by mass or may be used in the form of a solid.

The reaction in the present embodiment can be increased in reaction rate of epoxy resin synthesis by combination use with an organic solvent. The amount of the organic solvent used is preferably 5 to 70 parts by mass based on 100 parts by mass of the epihalohydrin.

The organic solvent used in the reaction is not particularly limited and examples thereof include ketones such as acetone and methyl ethyl ketone, alcohols such as methanol, ethanol, 1-propyl alcohol, isopropyl alcohol, 1-butanol, sec-butanol and tert-butanol, cellosolves such as methyl cellosolve and ethyl cellosolve, ethers such as tetrahydrofuran, 1,4-dioxane, 1,3-dioxane and diethoxyethane, and aprotic polar solvents such as acetonitrile, dimethylsulfoxide and dimethylformamide. These organic solvents may be each used singly, or may be used in appropriate combination of two or more kinds thereof for adjustment of polarity.

Such a reaction solvent is preferably a combination of the above organic solvent and water from the viewpoint of suitably providing the epoxy resin in the present embodiment. The proportion of use of water in such a mixed solvent is preferably in the range of 5 to 60 parts by mass, particularly preferably in the range of 10 to 50 parts by mass based on 100 parts by mass of the mixed solvent. When the proportion is equal to or more than the lower limit value, a rapid temperature rise in the reaction can be suppressed, and when the proportion is equal to or less than the upper limit value, the reaction rate of epoxidation can be inhibited from being reduced due to a reduction in alkaline catalyst concentration.

In a case where the alkaline catalyst used in the epoxidation reaction is an aqueous solution, the content of water contained in the aqueous solution is not included in the content of that defined as water in the mixed solvent.

The epoxy resin produced as described above can be reacted with alkali again and purified, thereby providing the epoxy resin composition of the present embodiment, which includes the epoxy compound (3), the epoxy compound (4) and other component at suitable contents described below.

An organic solvent for dissolution of the epoxy resin may be used in the reaction of the epoxy resin and alkali. The organic solvent used in the reaction is not particularly limited, and a ketone-based organic solvent is preferably used in terms of production efficiency, handleability, workability, and the like. An aprotic polar solvent may also be used from the viewpoint of a more decrease in amount of hydrolyzable chlorine.

Examples of the ketone-based organic solvent include ketone-based solvents such as methyl ethyl ketone, methyl isobutyl ketone and cyclohexanone. Methyl isobutyl ketone is particularly preferred in terms of the effect, ease of post-treatment, and the like. These may be used singly or as a mixture of two or more thereof.

Examples of the aprotic polar solvent include dimethylsulfoxide, diethylsulfoxide, dimethylsulfone, sulfolane, dimethylformamide, dimethylacetamide, and hexamethylphosphoramide. These may be used singly or as a mixture of two or more thereof. Among these aprotic polar solvents, dimethylsulfoxide is preferred because of being easily available and excellent in effect.

In a case where the ketone-based organic solvent and the aprotic polar solvent are mixed and used, these solvents are preferably used so that the proportion of the aprotic polar solvent is 1 to 30% by mass, in particular 5 to 20% by mass based on the total of these solvents.

The amount of the organic solvent used is an amount so that the concentration of the epoxy resin in the liquid subjected to treatment with alkali is usually 3 to 70% by mass, preferably 5 to 50% by mass, more preferably 10 to 40% by mass.

The alkali can be used in the form of a solid or solution of alkali metal hydroxide. Examples of the alkali metal hydroxide include potassium hydroxide and sodium hydroxide, preferably sodium hydroxide.

The alkali metal hydroxide may be used in the form of being dissolved in an organic solvent or water. The alkali metal hydroxide is preferably used as a solution in which the alkali metal hydroxide is dissolved in an aqueous solvent or an organic solvent.

The amount of the alkali metal hydroxide used is preferably 0.1 parts by mass or more and 6.0 parts by mass or less in terms of the solid content of the alkali metal hydroxide, based on 100 parts by mass of the epoxy resin. When the amount of the alkali metal hydroxide used is in this range, the ratio of each constituent component of the resulting epoxy resin composition can be easily adjusted in a suitable range. If the amount of the alkali metal hydroxide is out of the range, the epoxy resin composition including the epoxy compound (3), the epoxy compound (4) and other component in a suitable range of the ratio of each constituent component cannot be sometimes obtained.

The reaction temperature is preferably 20 to 150°C, more preferably 30 to 90°C. The reaction time is preferably 0.1 to 15 hours, more preferably 0.3 to 10 hours. If the reaction temperature is out of the range, the epoxy resin composition including the epoxy compound (3), the epoxy compound (4) and other component in a suitable range of the ratio of each constituent component cannot be sometimes obtained.

After the reaction, excess alkali metal hydroxide and a by-product salt can be removed by a method such as washing with water and furthermore the organic solvent can be removed by distillation under reduced pressure and/or steam distillation, thereby obtaining the epoxy resin composition of the present embodiment.

### [Epoxy compound (3)]

An epoxy resin obtained by the above method for producing an epoxy resin of the present embodiment is preferably the epoxy compound (3) represented by the formula (3).

The epoxy resin obtained by the method for producing an epoxy resin of the present embodiment preferably includes 70.0 to 99.9% by mass of the epoxy compound (3), and the content of the epoxy compound (3) is more preferably 80.0 to 97.0%, further preferably 82.0 to 94.0% by mass.

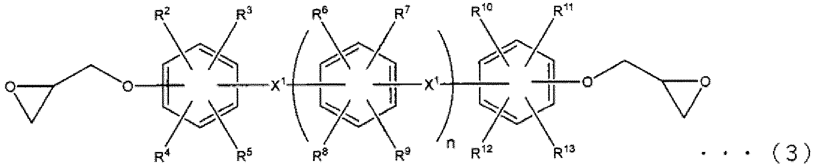

In the formula (3), R² to R¹³, X¹, and n have the same meanings as those in the formula (2). Herein, the same also applies to preferred R² to R¹³, X¹, and n.

Specific examples of the epoxy compound (3) include an epoxy resin obtained by converting, into an epoxy group, a hydroxyl group of various polyhydric phenols, for example, a bisphenol compound such as bisphenol A, bisphenol F, bisphenol S, bisphenol AD or bisphenol AF, a biphenol compound such as biphenol or tetramethylbiphenol, dihydroxydiphenyl ether, thiodiphenols, a phenol novolac resin, a cresol novolac resin, a phenol aralkyl resin, a biphenyl aralkyl resin, a naphthol aralkyl resin, a terpene phenol resin, a dicyclopentadiene phenol resin, a bisphenol A novolac resin, a naphthol novolac resin, brominated bisphenol A, or a brominated phenol novolac resin, or various phenol resins, for example, a polyhydric phenol resin obtained by condensation reaction of various phenols and various aldehydes such as benzaldehyde and crotonaldehyde, or a polyhydric phenol resin obtained by condensation reaction of a xylene resin and phenols, preferably an epoxy resin obtained by converting, into an epoxy group, a hydroxyl group of a bisphenol compound or a biphenol compound, more preferably an epoxy resin obtained by converting a hydroxyl group of a biphenol compound into an epoxy group, and particularly preferably an epoxy resin obtained by converting a hydroxyl group of tetramethylbiphenol into an epoxy group.

### [Epoxy compound (4)]

The epoxy resin obtained by the above method for producing an epoxy resin of the present embodiment preferably includes not only the epoxy compound (3), but also an epoxy compound (4) represented by the following formula (4).

The epoxy resin obtained by the above method for producing an epoxy resin of the present embodiment preferably includes 0.1 to 8.0% by mass of the epoxy compound (4), and the content of the epoxy compound (4) is more preferably 0.2 to 5.0% by mass, further preferably 0.4 to 3.0% by mass.

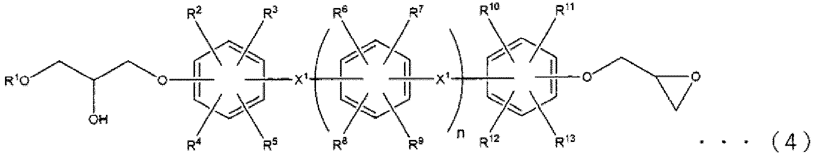

In the formula (4), X¹, R² to R¹³, and n have the same meanings as those in the formula (2) and the formula (3), and R¹ has the same meaning as that in the formula (1). Herein, the same also applies to preferred R¹ to R¹³, X¹, and n.

### [Other component]

The epoxy resin obtained by the above method for producing an epoxy resin of the present embodiment may further include other component (hereinafter, simply referred to as "other component".) than the epoxy compound (3) and the epoxy compound (4). The content of such other component in the epoxy resin obtained by the above method for producing an epoxy resin of the present embodiment is preferably 15.0% by mass or less. The epoxy resin obtained by the above method for producing an epoxy resin of the present embodiment, when including such other component, is one in which the total of the epoxy compound (3), the epoxy compound (4) and such other component is 100% by mass.

### [Epoxy resin composition (A)]

An epoxy resin composition (A) according to a second embodiment of the present invention includes 80.0 to 99.9% by mass of the epoxy compound (3) represented by the formula (3), namely, the epoxy resin (3), and 0.1 to 8.0% by mass of an epoxy compound represented by the following formula (5) (hereinafter, sometimes referred to as "epoxy compound (5)" or "epoxy resin (5)".).

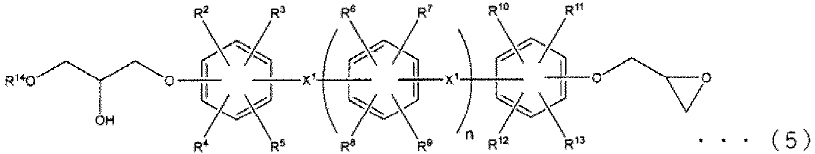

In the formula (5), X¹, R² to R¹³, and n have the same meanings as those in the formula (2) and the formula (3). Herein, the same also applies to preferred R² to R¹³, X¹, and n. R¹⁴ is a non-linear aliphatic hydrocarbon group having 3 to 8 carbon atoms.

R¹⁴ in the formula (5) is not particularly limited in terms of the structure thereof as long as it is a non-linear aliphatic hydrocarbon group having 3 to 8 carbon atoms, and the structure may be a structure such as a branched structure or a cyclic structure. The group optionally has a substituent such as a phenyl group or an alkoxy group.

Specific examples of the non-linear aliphatic hydrocarbon group having 3 to 8 carbon atoms, of R¹⁴, include an isopropyl group, a 1-methoxy-2-propyl group, a sec-butyl group, a tert-butyl group, an isopentyl group, a neopentyl group, a tert-pentyl group, a cyclopentyl group, an isohexyl group, a cyclohexyl group, a cycloheptyl group, a methylcyclohexyl group, a cyclooctyl group, a benzyl group, and a methylbenzyl group, and an alkyl group having a branched structure and having 3 to 8 carbon atoms is more preferred and examples thereof include an isopropyl group, a 1-methoxy-2-propyl group, a sec-butyl group, a tert-butyl group, an isopentyl group, a neopentyl group, and a tert-pentyl group. Such a branched chain optionally has an alkoxy group as a substituent to have an oxygen atom.

The content rate of the epoxy resin (3) in the epoxy resin composition (A) of the present embodiment is 80.0 to 99.9% by mass, preferably 82.0 to 97.0%, more preferably 85.0 to 94.0% by mass. If the content rate of the epoxy resin (3) exceeds the upper limit value, the epoxy resin has a high melting point and takes time until the occurrence of fluidity, and is inferior in productivity when mixed with other component such as a curing agent described below. On the other hand, if the content rate of the epoxy resin (3) is less than the lower limit value, the crystallization time in production of the epoxy resin composition is long, thereby causing poor productivity.

The content rate of the epoxy resin (5) in the epoxy resin composition (A) of the present embodiment is 0.1 to 8.0% by mass, preferably 0.2 to 5.0% by mass, more preferably 0.4 to 3.0% by mass. If the content rate of the epoxy resin (5) is less than the lower limit value, the epoxy resin has a high melting point and takes a time until the occurrence of fluidity, and is inferior in productivity when mixed with other component such as a curing agent described below. On the other hand, if the content rate of the epoxy resin (5) exceeds the upper limit, the glass transition temperature of a cured product with the epoxy resin composition is lowered.

The epoxy resin composition (A) of the present embodiment may further include other component (hereinafter, simply referred to as "other component".) than the epoxy resin (3) and the epoxy resin (5). The content of such other component in the epoxy resin composition (A) is preferably 15.0% by mass or less. The epoxy resin composition (A) of the present embodiment, when includes such other component, is one in which the total of the epoxy resin (3), the epoxy resin (5) and such other component is 100% by mass.

The content of the epoxy resin (5) in the epoxy resin composition (A) can be controlled by adjusting the amount of a compound (6) described below used in the method for producing an epoxy resin of the present embodiment. In other words, as a larger amount of the compound (6) is used, the content of the epoxy resin (5) can be increased, and as a smaller amount of the compound (6) is used, the content of the epoxy resin (5) can be decreased.

The content of each of the constituent components of the epoxy resin composition (A) of the present embodiment can be measured with, for example, high-performance liquid chromatography analysis (hereinafter, LC analysis).

The epoxy resin composition (A) of the present embodiment includes a plurality of components, for example, the epoxy resin (3) and the epoxy resin (5), and thus is defined as "epoxy resin composition". It is noted that "epoxy resin" in the technical field of epoxy resin is acquired as not one made of a single component, but one made of multiple components, "composition". Therefore, the epoxy resin composition (A) of the present embodiment is expressed as "epoxy resin" in the art and may also be sold as "epoxy resin". In addition, "epoxy compound (not cured)" is called "epoxy resin" in the art. Therefore, not only the compound represented by the formula (3), but also the compound represented by the formula (5) is called "epoxy resin".

The epoxy resin composition (A) of the present embodiment preferably has an epoxy equivalent of 180 to 193 g /eq, for example, when tetramethylbiphenol is used as a raw material, from the viewpoint that the epoxy resin achieves excellent electric properties and an epoxy resin composition (B) including a curing agent achieves excellent productivity. The epoxy resin composition (A) of the present embodiment more preferably has an epoxy equivalent of 184 to 192 g /eq, for example, when tetramethylbiphenol is used as a raw material, from the viewpoint that productivity in production of the epoxy resin composition (A) is more enhanced. It is considered that the epoxy equivalent is in the above specified range to impart excellent properties described above.

In the present embodiment, "epoxy equivalent" is defined as "mass of an epoxy resin including 1 equivalent of an epoxy group" and can be measured according to JIS K7236.

The content of hydrolyzable chlorine in the epoxy resin composition (A) of the present embodiment (hereinafter, sometimes referred to as "amount of hydrolyzable chlorine".) is preferably 1000 ppm by mass or less. The amount of hydrolyzable chlorine in the epoxy resin composition (A) is more preferably 700 ppm by mass or less from the viewpoint of imparting better electric properties.

Examples of the method for measuring the amount of hydrolyzable chlorine include a method including dissolving about 0.5 g of the epoxy resin in 20 mL of dioxane, refluxing the solution in 5 mL of a 1 N KOH/ethanol solution for 30 minutes, and then performing titration with a 0.01 N silver nitrate solution.

In order to reduce the amount of hydrolyzable chlorine in the epoxy resin composition (A), an epoxy resin produced by the method for producing an epoxy resin of the first embodiment may be further reacted with alkali and purified, as described above.

The melting point of the epoxy resin composition (A) of the present embodiment is preferably 108°C or less. When the melting point is equal to or less than the value, mixing at a lower temperature can be achieved in production of an epoxy resin composition (B) described below and production in a condition of a low load on the environment can be achieved. In this regard, the melting point of the epoxy resin composition (A) of the present embodiment is preferably 50°C or more from the viewpoint of suppression of melting at a high temperature during transport.

The crystallization time of the epoxy resin composition (A) of the present embodiment is preferably 1500 seconds or less, more preferably 1000 seconds or less. When the crystallization time is less than the value, solidification can be achieved in a short time and productivity is excellent in a process for producing an epoxy resin composition (B). In this regard, the crystallization time of the epoxy resin composition (A) of the present embodiment is preferably 60 seconds or more from the viewpoint of prevention of fixation due to crystallization at an extraction port in epoxy resin production.

### <Method for producing epoxy resin composition (A)>

The method for producing the epoxy resin composition (A) of the present embodiment is not particularly limited, the epoxy resin composition can be produced in the same manner as in the method for producing an epoxy resin of the first embodiment except that a compound represented by the following formula (6) (hereinafter, sometimes referred to as "compound (6)".) is used instead of the compound (1) to generate the epoxy resin (5) instead of the epoxy compound (4), in the method for producing an epoxy resin of the first embodiment in the presence of the compound (1), the method including reacting the raw material phenol compound and the epihalohydrin to produce the epoxy resin, and each preferred condition is also in the same manner and the description overlapped is here omitted.

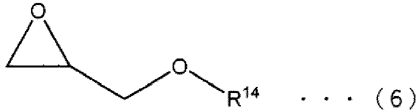

In the formula (6), R¹⁴ has the same meaning as that in the formula (5). Herein, the same also applies to preferred R¹⁴.

### [Epoxy resin composition (B)]

An epoxy resin composition (B) according to a third embodiment of the present invention includes at least the above epoxy resin composition (A) of the second embodiment, and a curing agent.

Other epoxy resin than the epoxy resin included in the epoxy resin composition (A) of the second embodiment (hereinafter, sometimes simply referred to as "other epoxy resin".), a curing accelerator, an inorganic filler, a coupling agent, and/or the like can be, if necessary, appropriately blended with the epoxy resin composition (B) of the present embodiment.

### [Curing agent]

The curing agent in the present embodiment means a substance contributing to crosslinking reaction between epoxy groups of the epoxy resin and/or chain extension reaction of the epoxy resin. In the present invention, even one called "curing accelerator" is usually meant to be regarded as the curing agent as long as such one is a substance contributing to crosslinking reaction between epoxy groups of the epoxy resin and/or chain extension reaction of the epoxy resin.

The content of the curing agent in the epoxy resin composition (B) of the present embodiment is preferably 0.1 to 1000 parts by mass, more preferably 500 parts by mass or less, further preferably 300 parts by mass or less based on 100 parts by mass of the total epoxy resin component as the solid content.

The "solid content" in the present embodiment means a component except for a solvent, and encompasses not only an epoxy resin having solid properties, but also a semi-solid and a viscous liquid material. The "total epoxy resin component" corresponds to the amount of the epoxy resin included in the epoxy resin composition (B) of the present embodiment, and in a case where the epoxy resin composition (B) of the present embodiment includes only the epoxy resin composition (A), the total epoxy resin component corresponds to the amount of the epoxy resin in the epoxy resin composition (A) (epoxy resin (3) and epoxy resin (5), and epoxy resin other than epoxy resin (3) and epoxy resin (5) in other component). In a case where the epoxy resin composition (B) of the present embodiment includes the epoxy resin composition (A) and other epoxy resin, the total epoxy resin component corresponds to the total of the epoxy resin in the epoxy resin composition (A) and such other epoxy resin.

The curing agent is not particularly limited, and any curing agent commonly known as an epoxy resin curing agent can be used. Examples include a phenol-based curing agent, an amine-based curing agent such as aliphatic amine, polyetheramine, alicyclic amine, or aromatic amine, an acid anhydride-based curing agent, an amide-based curing agent, tertiary amine, and imidazoles.

In particular, the epoxy resin composition (B) of the present embodiment can include a phenol-based curing agent to obtain excellent heat resistance, stress resistance, water absorption resistance, flame retardance, and the like. Therefore, the epoxy resin composition preferably includes a phenol-based curing agent as the curing agent. The epoxy resin composition preferably includes an acid anhydride-based curing agent or an amide-based curing agent from the viewpoint of heat resistance and the like. Imidazoles are also preferably used from the viewpoint of allowing curing reaction to sufficiently progress and enhancing heat resistance.

The curing agent may be used singly or in combination of two or more kinds thereof. In a case where the curing agent is used in combination of two or more kinds thereof, a mixed curing agent may be used which is prepared by mixing these curing agents in advance, or each component of such curing agents may be separately added and simultaneously mixed when each component of the epoxy resin composition (B) is mixed.

### <Phenol-based curing agent>

Specific examples of the phenol-based curing agent include various polyhydric phenols, for example, bisphenol A, bisphenol F, bisphenol S, bisphenol AD, hydroquinone, resorcin, methylresorcin, biphenol, tetramethylbiphenol, dihydroxynaphthalene, dihydroxydiphenyl ether, thiodiphenols, a phenol novolac resin, a cresol novolac resin, a phenol aralkyl resin, a biphenyl aralkyl resin, a naphthol aralkyl resin, a terpene phenol resin, a dicyclopentadiene phenol resin, a bisphenol A novolac resin, a trisphenolmethane-type resin, a naphthol novolac resin, brominated bisphenol A, and a brominated phenol novolac resin, and various phenol resins, for example, polyhydric phenol resins obtained by condensation reaction of various phenols and various aldehydes such as benzaldehyde, hydroxybenzaldehyde, crotonaldehyde and glyoxal, polyhydric phenol resins obtained by condensation reaction of a xylene resin and phenols, a co-condensation resin of heavy oil or pitch, phenols and formaldehydes, a phenol-benzaldehyde-xylylene dimethoxide polycondensate, a phenol-benzaldehyde-xylylene dihalide polycondensate, a phenol-benzaldehyde-4,4'-dimethoxide biphenyl polycondensate, and a phenol-benzaldehyde-4,4'-dihalide biphenyl polycondensate.

The phenol-based curing agent may be used singly, or may be used in any combination of two or more kinds thereof at any blending ratio.

Among the above phenol-based curing agents, preferred is, for example, a phenol novolac resin (for example, a compound represented by the following formula (7)), a phenol aralkyl resin (for example, a compound represented by the following formula (8)), a biphenyl aralkyl resin (for example, a compound represented by the following formula (9)), a naphthol novolac resin (for example, a compound represented by the following formula (10)), a naphthol aralkyl resin (for example, a compound represented by the following formula (11)), a trisphenolmethane-type resin (for example, a compound represented by the following formula (12)), a phenol-benzaldehyde-xylylene dimethoxide polycondensate (for example, a compound represented by the following formula (13)), a phenol-benzaldehyde-xylylene dihalide polycondensate (for example, a compound represented by the following formula (13)), a phenol-benzaldehyde-4,4'-dimethoxide biphenyl polycondensate (for example, a compound represented by the following formula (14)), or a phenol-benzaldehyde-4,4'-dihalide biphenyl polycondensate (for example, a compound represented by the following formula (14)), from the viewpoint of heat resistance after curing, curability, and the like of the composition. In particular, preferred is a phenol novolac resin (for example, a compound represented by the following formula (7)), a phenol aralkyl resin (for example, a compound represented by the following formula (8)), a biphenyl aralkyl resin (for example, a compound represented by the following formula (9)), a phenol-benzaldehyde-xylylene dimethoxide polycondensate (for example, a compound represented by the following formula (13)), a phenol-benzaldehyde-xylylene dihalide polycondensate (for example, a compound represented by the following formula (13)), a phenol-benzaldehyde-4,4'-dimethoxide biphenyl polycondensate (for example, a compound represented by the following formula (14)), or a phenol-benzaldehyde-4,4'-dihalide biphenyl polycondensate (for example, a compound represented by the following formula (14)).

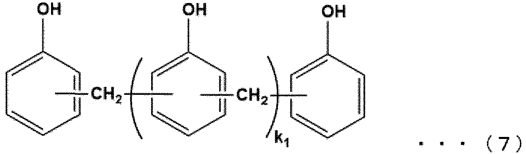

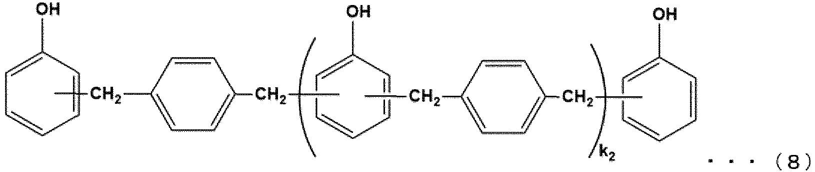

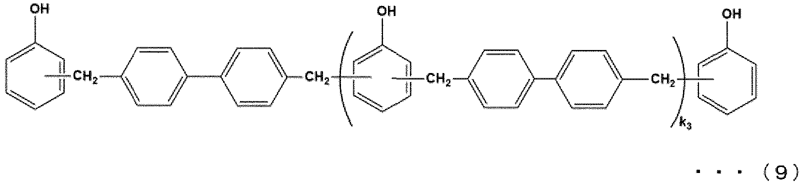

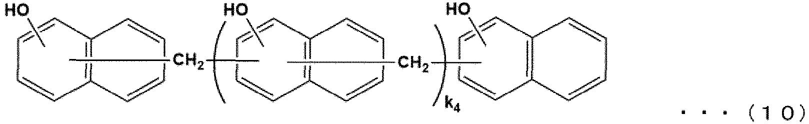

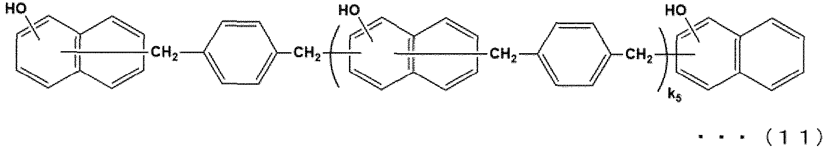

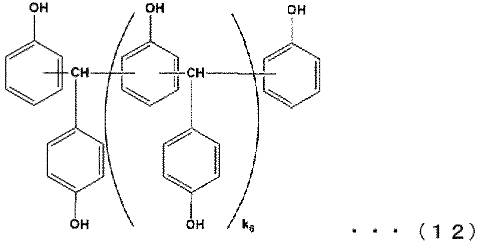

In the formulae (7) to (12), k₁ to k₆ each represents the number of 0 or more.

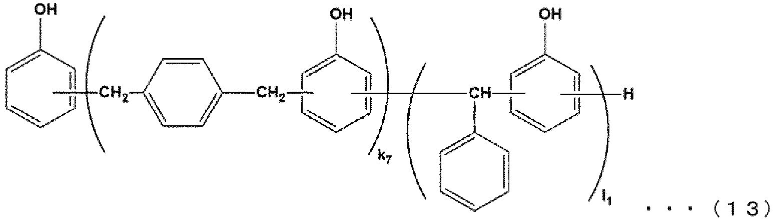

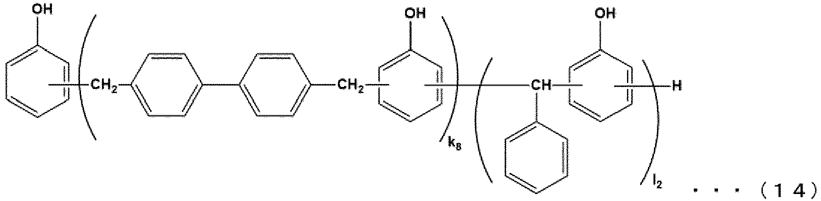

In the formulae (13) and (14), k₇, k₈, l₁, and l₂ each represents the number of 1 or more.

The amount of the phenol-based curing agent blended is preferably 0.1 to 1000 parts by mass, more preferably 500 parts by mass or less, further preferably 300 parts by mass or less, particularly preferably 100 parts by mass or less based on 100 parts by mass of the total epoxy resin component in the epoxy resin composition (B).

### <Amine-based curing agent>

Examples of the amine-based curing agent (except for tertiary amine.) include aliphatic amines, polyetheramines, alicyclic amines, and aromatic amines.

Examples of the aliphatic amines include ethylenediamine, 1,3-diaminopropane, 1,4-diaminopropane, hexamethylenediamine, 2,5-dimethylhexamethylenediamine, trimethylhexamethylenediamine, diethylenetriamine, iminobispropylamine, bis(hexamethylene)triamine, triethylenetetramine, tetraethylenepentamine, pentaethylenehexamine, N-hydroxyethylethylenediamine, and tetra(hydroxyethyl)ethylenediamine.

Examples of the polyetheramines include triethylene glycoldiamine, tetraethylene glycoldiamine, diethylene glycolbis(propylamine), polyoxypropylenediamine, and polyoxypropylenetriamines.

Examples of the alicyclic amines include isophoronediamine, metacenediamine, N-aminoethylpiperazine, bis(4-amino-3-methyldicyclohexyl)methane, bis(aminomethyl)cyclohexane, 3,9-bis(3-aminopropyl)-2,4,8,10-tetraoxaspiro(5,5)undecane, and norbornenediamine.

Examples of the aromatic amines include tetrachloro-p-xylenediamine, m-xylenediamine, p-xylenediamine, m-phenylenediamine, o-phenylenediamine, p-phenylenediamine, 2,4-diaminoanisole, 2,4-toluenediamine, 2,4-diaminodiphenylmethane, 4,4'-diaminodiphenylmethane, 4,4'-diamino-1,2-diphenylethane, 2,4-diaminodiphenylsulfone, 4,4'-diaminodiphenylsulfone, m-aminophenol, m-aminobenzylamine, benzyldimethylamine, 2-(dimethylaminomethyl)phenol, triethanolamine, methylbenzylamine, α-(m-aminophenyl)ethylamine, α-(p-aminophenyl)ethylamine, diaminodiethyldimethyldiphenylmethane, and α,α'-bis(4-aminophenyl)-p-diisopropylbenzene.

The amine-based curing agent may be used singly, or may be used in any combination of two or more kinds thereof at any blending ratio.

The amine-based curing agent is preferably used so that the equivalent ratio of a functional group in the curing agent relative to an epoxy group in the total epoxy resin component included in the epoxy resin composition (B) is in the range of 0.8 to 1.5. This range is preferred because an unreacted epoxy group and the functional group in the curing agent hardly remain.

Examples of the tertiary amine include 1,8-diazabicyclo(5,4,0)undecene-7, triethylenediamine, benzyldimethylamine, triethanolamine, dimethylaminoethanol, and tris(dimethylaminomethyl)phenol.

The tertiary amine may be used singly, or may be used in any combination of two or more kinds thereof at any blending ratio.

The tertiary amine is preferably used so that the equivalent ratio of a functional group in the curing agent relative to an epoxy group in the total epoxy resin component included in the epoxy resin composition (B) is in the range of 0.8 to 1.5. This range is preferred because an unreacted epoxy group and the functional group in the curing agent hardly remain.

### <Acid anhydride-based curing agent>

Examples of the acid anhydride-based curing agent include acid anhydride and a modified product of the acid anhydride.

Examples of the acid anhydride include phthalic anhydride, trimellitic anhydride, pyromellitic anhydride, benzophenonetetracarboxylic anhydride, dodecenylsuccinic anhydride, polyadipic anhydride, polyazelaic anhydride, polysebacic anhydride, poly(ethyloctadecanedioic)anhydride, poly(phenylhexadecanedioic)anhydride, tetrahydrophthalic anhydride, methyltetrahydrophthalic anhydride, methylhexahydrophthalic anhydride, hexahydrophthalic anhydride, methyl himic anhydride, trialkyltetrahydrophthalic anhydride, methylcyclohexene dicarboxylic anhydride, methylcyclohexene tetracarboxylic anhydride, ethylene glycol bistrimellitate dianhydride, het anhydride, nadic anhydride, methylnadic anhydride, 5-(2,5-dioxotetrahydro-3-furanyl)-3-methyl-3-cyclohexane-1,2-dicarboxylic anhydride, 3,4-dicarboxy-1,2,3,4-tetrahydro-1-naphthalenesuccinic dianhydride, and 1-methyl-dicarboxy-1,2,3,4-tetrahydro-1-naphthalenesuccinic dianhydride.

Examples of the modified product of the acid anhydride include a modified acid anhydride with glycol. Examples of the glycol usable in the modification include alkylene glycols such as ethylene glycol, propylene glycol and neopentyl glycol, and polyether glycols such as polyethylene glycol, polypropylene glycol and polytetramethylene ether glycol. Furthermore, a copolymerized polyether glycol of two or more glycols and/or polyether glycols among the above can also be used.

The modified product of the acid anhydride is preferably obtained by modifying 1 mol of the acid anhydride with 0.4 mol or less of the glycol. When the amount modified is equal to or less than the upper limit value, the epoxy resin composition tends to be not too high in viscosity and be improved in workability. The rate of curing reaction with the epoxy resin also tends to be improved.

The acid anhydride-based curing agent may be used singly, or may be used in any combination of two or more kinds thereof in any blending amounts.

The acid anhydride-based curing agent, when used, is preferably used so that the equivalent ratio of a functional group in the curing agent relative to an epoxy group in the total epoxy resin component in the epoxy resin composition (B) is in the range of 0.8 to 1.5. This range is preferred because an unreacted epoxy group and the functional group in the curing agent hardly remain.

### <Amide-based curing agent>

Examples of the amide-based curing agent include dicyandiamide and its derivative, and a polyamide resin. The amide-based curing agent may be used singly, or may be mixed and used in any combination of two or more kinds thereof at any ratio.

In a case where the amide-based curing agent is used, the amide-based curing agent is preferably used so as to be at a proportion of 0.1 to 20% by mass relative to the total of the total epoxy resin component and the amide-based curing agent in the epoxy resin composition (B).

### <Imidazoles>

Examples of the imidazoles include 2-phenylimidazole, 2-ethyl-4(5)-methylimidazole, 2-phenyl-4-methylimidazole, 1-benzyl-2-methylimidazole, 1-benzyl-2-phenylimidazole, 1-cyanoethyl-2-undecylimidazole, 1-cyano-2-phenylimidazole, 1-cyanoethyl-2-undecylimidazole trimellitate, 1-cyanoethyl-2-phenylimidazolium trimellitate, 2,4-diamino-6-[2'-methylimidazolyl-(1')]-ethyl-s-triazine, 2,4-diamino-6-[2'-ethyl-4'-methylimidazolyl-(1)]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, and an adduct of an epoxy resin and such imidazoles.

The imidazoles, while having a catalytic ability and thus can also be generally classified as a curing accelerator, are intended to be classified as the curing agent in the present embodiment.

Such imidazoles may be used singly, or may be mixed and used in any combination of two or more kinds thereof at any ratio.

In a case where the imidazoles are used, the imidazoles are preferably used so as to be at a proportion of 0.1 to 20% by mass relative to the total of the total epoxy resin component and the imidazoles in the epoxy resin composition (B).

### <Other curing agent>

Other curing agent than the curing agent can be used in the epoxy resin composition (B) of the present embodiment. Such other curing agent is not particularly limited, and any curing agent generally known as a curing agent for epoxy resins can be used.

Such other curing agent may be used singly or in combination of two or more kinds thereof.

### [Other epoxy resin]

The epoxy resin composition (B) of the present embodiment can further include other epoxy resin than the epoxy resin composition (A). Such other epoxy resin can be included to enhance heat resistance, stress resistance, water absorption resistance, flame retardance, and the like of the epoxy resin composition (B) of the present invention.

All epoxy resins other than the epoxy resins (mainly the epoxy resin (3) and the epoxy resin (5)) included in the epoxy resin composition (A) correspond to other epoxy resins usable in the epoxy resin composition (B) of the present embodiment.

Specific examples include a bisphenol A type epoxy resin, a trisphenolmethane type epoxy resin, an anthracene type epoxy resin, a phenol-modified xylene resin type epoxy resin, a bisphenol cyclododecyl type epoxy resin, a bisphenol diisopropylideneresorcin type epoxy resin, a bisphenol F type epoxy resin, a bisphenol AD type epoxy resin, a hydroquinone type epoxy resin, a methylhydroquinone type epoxy resin, a dibutylhydroquinone type epoxy resin, a resorcin type epoxy resin, a methylresorcin type epoxy resin, a biphenol type epoxy resin, a tetramethylbiphenol type epoxy resin other than the epoxy resins (1) and (2) in the epoxy resin composition (A), a tetramethyl bisphenol F type epoxy resin, a dihydroxydiphenyl ether type epoxy resin, an epoxy resin derived from thiodiphenols, a dihydroxynaphthalene type epoxy resin, a dihydroxyanthracene type epoxy resin, a dihydroxydihydroanthracene type epoxy resin, a dicyclopentadiene type epoxy resin, an epoxy resin derived from dihydroxystilbenes, a phenol novolac type epoxy resin, a cresol novolac type epoxy resin, a bisphenol A novolac type epoxy resin, a naphthol novolac type epoxy resin, a phenol aralkyl type epoxy resin, a naphthol aralkyl type epoxy resin, a biphenyl aralkyl type epoxy resin, a terpene phenol type epoxy resin, a dicyclopentadiene phenol type epoxy resin, an epoxy resin derived from a condensate of phenolhydroxybenzaldehyde, an epoxy resin derived from a condensate of phenol-crotonaldehyde, an epoxy resin derived from a condensate of phenol-glyoxal, a co-condensation resin of heavy oil or pitch, an epoxy resin derived from phenols and formaldehydes, an epoxy resin derived from diaminodiphenylmethane, an epoxy resin derived from aminophenol, an epoxy resin derived from xylenediamine, an epoxy resin derived from methylhexahydrophthalic acid, and an epoxy resin derived from dimer acid.

These may be used singly, or may be used in any combination of two or more kinds thereof at any blending ratio.

Among the above epoxy resins, particularly preferred is a bisphenol A type epoxy resin, a tetramethylbiphenol type epoxy resin other than the epoxy resins (3) and (5) in the epoxy resin composition (A), a 4,4'-biphenol type epoxy resin, a biphenyl aralkyl type epoxy resin, a phenol aralkyl type epoxy resin, a dihydroxyanthracene type epoxy resin, a dicyclopentadiene type epoxy resin, an ortho-cresol novolac type epoxy resin, or a trisphenolmethane type epoxy resin from the viewpoint of fluidity of the composition and furthermore heat resistance, water absorption resistance, flame retardance and the like of a cured product.

In a case where the epoxy resin composition (B) of the present embodiment includes such other epoxy resin, the content is preferably 0.01 to 60 parts by mass, more preferably 40 parts by mass or less, further preferably 30 parts by mass or less, particularly preferably 20 parts by mass or less, and more preferably 1 part by mass or more based on 100 parts by mass of the total epoxy resin component in the composition.

### [Curing accelerator]

The epoxy resin composition (B) of the present embodiment preferably includes a curing accelerator. The curing accelerator can be included to shorten the curing time and lower the curing temperature, thereby easily providing a desired cured product.

The curing accelerator is not particularly limited. Specific examples include organic phosphines, a phosphorus-based compound such as a phosphonium salt, tetraphenylborate, organic acid dihydrazide, and a boron halide-amine complex.

Examples of the phosphorus-based compound usable as the curing accelerator include organic phosphines such as triphenylphosphine, diphenyl(p-tolyl)phosphine, tris(alkylphenyl)phosphine, tris(alkoxyphenyl)phosphine, tris(alkyl-alkoxyphenyl)phosphine, tris(dialkylphenyl)phosphine, tris(trialkylphenyl)phosphine, tris(tetraalkylphenyl)phosphine, tris(dialkoxyphenyl)phosphine, tris(trialkoxyphenyl)phosphine, tris(tetraalkoxyphenyl)phosphine, trialkylphosphine, dialkylarylphosphine or alkyldiarylphosphine, a complex of such organic phosphaines and organoborons, and a compound obtained by adding such organic phosphines and maleic anhydride, and a quinone compound such as 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2,3-dimethoxy-1,4-benzoquinone or phenyl-1,4-benzoquinone, or a compound such as diazophenylmethane.

### Among the above curing accelerators, organic phosphines or a phosphonium salt is preferred, and organic phosphines are most preferred

Such curing accelerators exemplified above may be used singly, or may be mixed and used in any combination of two or more kinds thereof at any ratio.

The curing accelerator is preferably used in the range of 0.1 weight and 20 parts by mass or less, more preferably 0.5 parts by mass or more, further preferably 1 part by mass or more, and more preferably 15 parts by mass or less, further preferably 10 parts by mass or less based on 100 parts by mass of the total epoxy resin component in the epoxy resin composition (B). When the content of the curing accelerator is equal to or more than the lower limit value, a favorable curing acceleration effect can be obtained. The content of the curing accelerator is preferably equal to or less than the upper limit value because desired cured product properties are easily obtained.

### [Inorganic filler]

An inorganic filler can be blended with the epoxy resin composition (B) of the present embodiment. Examples of the inorganic filler include molten silica, crystalline silica, a glass powder, alumina, calcium carbonate, calcium sulfate, talc, and boron nitride. These may be used singly, or may be used in any combination of two or more kinds thereof at any blending ratio. In particular, in the case of use in the semiconductor sealing application, pulverized and/or spherical, molten and/or crystalline silica powder filler(s) are/is preferred.

The inorganic filler can be used to allow the thermal expansion coefficient of a semiconductor sealant to be close to that of a silicon chip or a lead frame located internally, in the case of use of the epoxy resin composition (B) as the semiconductor sealant. The amount of water absorption by the entire semiconductor sealant can be decreased, and thus solder cracking resistance can be enhanced.

The average particle size of the inorganic filler is usually 1 to 50 µm, preferably 1.5 to 40 µm, more preferably 2 to 30 µm. The average particle size is preferably equal to or more than the lower limit value because the melt viscosity is not too high and the fluidity is hardly reduced.

The average particle size of the inorganic filler is preferably equal to or less than the upper limit value because a narrow gap of a mold is hardly clogged by the filler in molding and the filling ability of a material is easily enhanced.

In a case where the inorganic filler is used in the epoxy resin composition (B) of the present embodiment, the inorganic filler is preferably blended in the range of 60 to 95% by mass relative to the entire epoxy resin composition.

### [Release agent]

A release agent can be blended with the epoxy resin composition (B) of the present embodiment. The release agent here used can be, for example, natural wax, such as carnauba wax, synthetic wax such as polyethylene wax, higher fatty acids and metal salts thereof, such as stearic acid and zinc stearate, and a hydrocarbon-based release agent such as paraffin. These may be used singly, or may be used in any combination of two or more kinds thereof at any blending ratio.

In a case where the release agent is blended in the epoxy resin composition (B) of the present embodiment, the amount of the release agent blended is preferably 0.1 to 5.0 parts by mass, more preferably 0.5 to 3.0 parts by mass based on 100 parts by mass of the total epoxy resin component in the epoxy resin composition (B). An amount of the release agent blended, in the above range, is preferred because not only curing properties of the epoxy resin composition (B) are maintained, but also favorable releasability can be exhibited.

### [Coupling agent]

A coupling agent is preferably blended with the epoxy resin composition (B) of the present embodiment. The coupling agent is preferably used in combination with the inorganic filler. The coupling agent can be blended to enhance adhesiveness between the epoxy resin as a matrix and the inorganic filler. Examples of the coupling agent include a silane coupling agent and a titanate coupling agent.

Examples of the silane coupling agent include epoxy silanes such as γ-glycidoxypropyltrimethoxysilane, γ-glycidoxypropyltriethoxysilane and β-(3,4-epoxy cyclohexyl)ethyltrimethoxysilane, aminosilanes such as γ-aminopropyltriethoxysilane, N-β(aminoethyl)γ-aminopropyltrimethoxysilane, N-β(aminoethyl)γ-aminopropylmethyldimethoxysilane, γ-aminopropyltrimethoxysilane and γ-ureidopropyltriethoxysilane, mercaptosilanes such as 3-mercaptopropyltrimethoxysilane, vinylsilanes such as p-styryltrimethoxysilane, vinyltrichlorosilane, vinyltris(β-methoxyethoxy)silane, vinyltrimethoxysilane, vinyltriethoxysilane and γ-methacryloxypropyltrimethoxysilane, and furthermore polymer type epoxy-based, amino-based, and vinyl-based silanes.

Examples of the titanate coupling agent include isopropyl triisostearoyl titanate, isopropyl tri(N-aminoethyl-aminoethyl)titanate, diisopropyl bis(dioctylphosphate)titanate, tetraisopropyl bis(dioctylphosphite)titanate, tetraoctyl bis(ditridecylphosphite)titanate, tetra(2,2-diallyloxymethyl-1-butyl)bis(ditridecyl)phosphite titanate, bis(dioctylpyrophosphate)oxyacetate titanate, and bis(dioctylpyrophosphate)ethylene titanate.

Such a coupling agent may be used singly, or may be mixed and used in any combination of two or more kinds thereof at any ratio.

In a case where the coupling agent is used in the epoxy resin composition (B) of the present embodiment, the amount thereof blended is preferably 0.1 to 3.0 parts by mass based on 100 parts by mass of the total epoxy resin component. When the amount of the coupling agent blended is equal to or more than the lower limit value, the effect of enhancing close contact ability between the epoxy resin as a matrix and the inorganic filler by blending the coupling agent tends to be increased. The amount of the coupling agent blended is preferably equal to or less than the upper limit value because the coupling agent is hardly bled out from a cured product obtained.

### [Other blending component]

Other component than the above (in the present invention, sometimes referred to as "other blending component".) can be blended with the epoxy resin composition (B) of the present embodiment. Examples of such other blending component include a flame retardant, a plasticizer, a reactive diluent, and a pigment. Such other blending component can be, if necessary, appropriately blended. Other component than the above may be blended with the epoxy resin composition (B) of the present embodiment.

Examples of the flame retardant used in the epoxy resin composition (B) of the present embodiment include halogen-based flame retardants such as a brominated epoxy resin and a brominated phenol resin, antimony compounds such as antimony trioxide, phosphorus-based flame retardants such as red phosphorus, phosphates and phosphines, nitrogen-based flame retardants such as a melamine derivative, and inorganic flame retardants such as aluminum hydroxide and magnesium hydroxide.

The method for curing the epoxy resin composition (B) of the present embodiment is not particularly limited. A cured product can be usually obtained by thermal curing reaction with heating. The curing temperature in the thermal curing reaction is preferably appropriately selected depending on the type of the curing agent used. For example, in a case where the phenol-based curing agent is used, the curing temperature is usually 130 to 300°C. A curing accelerator can also be added to such a curing agent to lower the curing temperature. The reaction time is preferably 1 to 20 hours, more preferably 2 to 18 hours, further preferably 3 to 15 hours. The reaction time is preferably equal to or more than the lower limit value because the curing reaction tends to easily sufficiently progress. The reaction time is preferably equal to or less than the upper limit value because degradation due to heating and the energy loss during heating are easily reduced.

### [Application]

A cured product with the curable resin composition (B) of the present embodiment exhibits low water absorption, is excellent in thermal cracking resistance when serves as an electronic material, and is excellent in electric reliability when used for a long period.

Accordingly, the curable resin composition (B) of the present embodiment and a cured product thereof can be effectively used in any application as long as such any application is an application where such physical properties are required. For example, the composition and the cured product can be suitably used in any application, for example, in the paint field of, for example, an optical material, paint for automobiles such as electrodeposition paint for automobiles, anti-corrosive paint for ships/bridges, or paint for interior coatings of beverage cans; in the electric/electronic field of, for example, a composite material, a layered plate, a semiconductor sealant, a liquid insulating sealant, insulating powder paint, or one for coil impregnation; or in the civil engineering/building/adhesive field of, for example, aseismic reinforcement of bridges, concrete reinforcing, a floor material of architecture, a lining of water utility, draining/pervious pavements, or an adhesive for structures/vehicles/airplanes. In particular, the composition is useful for electric/electronic components.

The epoxy resin composition (B) of the present embodiment may be cured and then used for the above application, or may be cured in a production process in the above application.

### [Layered plate]

Examples of a method for producing a layered plate with the curable resin composition (B) of the present embodiment include a method including producing the layered plate by heating and pressurizing and thus curing a layered product including a prepreg where a fibrous substrate is impregnated with the above resin varnish made of the curable resin composition (B) of the present embodiment.

More specifically, a fibrous substrate is impregnated with the resin varnish, and a solvent is removed to provide a prepreg. The prepreg and other substrate, if necessary, used are stacked to form a layered product, and the layered product is heated and pressurized and thus cured to provide the layered plate.

One, or two or more such prepregs may be stacked in the layered product. Other substrate than the prepreg may be stacked in the layered product. Examples of such other substrate include metal foil such as copper foil.

Examples of the fiber constituting the fibrous substrate include inorganic fibers such as a glass fiber, a carbon fiber, a ceramic fiber and a stainless fiber; natural fibers such as cotton, linen, and paper; and synthetic organic fibers such as a polyester resin and a polyamide resin. Any one of these fibers may be used singly, or two or more thereof may be used in combination.

The form of the fibrous substrate is not particularly limited, and examples thereof include a short fiber, a yarn, a mat, and a sheet.

The amount of the resin varnish for impregnation of the fibrous substrate is not particularly limited, and, for example, the amount of the solid content of the resin varnish for impregnation is set to be about 30 to 50% by mass relative to the fibrous substrate (100% by mass).

The heating temperature in heating and pressurizing of the layered product is preferably the above curing temperature. A pressurizing condition of 2 to 20 kN/m² is preferred.

The layered plate thus produced includes a fiber-reinforced resin layer including the fibrous substrate and the cured product of the resin varnish. The number of such fiber-reinforced resin layers included in the layered plate may be one, or two or more. As described above, the layered plate may have a layer of metal foil such as copper foil.

### [Sealant]

In a case where the curable resin composition (B) of the present embodiment is used as a sealant, the shape of a sealant to which the curable resin composition of the present embodiment is applied is not particularly limited, and, for example, the same shape as that adopted in a known semiconductor or the like can be adopted.

Examples of a method for forming a sealant with the curable resin composition (B) of the present embodiment include a method for sealing a semiconductor with a transfer molding method, a compression molding method, or the like.

### EXAMPLES

Hereinafter, the present invention is more specifically described with reference to Examples. The present invention is not limited to the following Examples at all. Various production conditions and the evaluation result values in the following Examples have the meaning of a preferred upper limit or lower limit value in embodiments of the present invention, and a preferred range may be a range defined by a combination of the above upper or lower value and a value in the following Examples, or a combination of values in such Examples.

### [Raw materials used, and the like]

Structural formulae of raw materials used, reaction products, and the like, in the following Examples and Comparative Examples, are as follows.

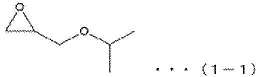

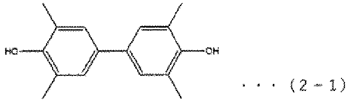

### Tetramethylbiphenol: manufactured by Mitsubishi Chemical Corporation

### <Epoxy resin (3)>

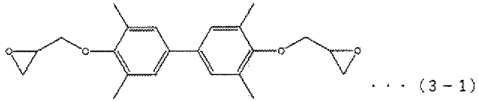

### <Epoxy resin (4) or (5)>

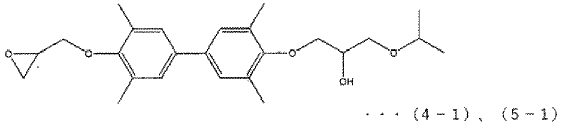

### [Measurement/evaluation methods]

Measurement/evaluation methods of physical properties of epoxy resins (epoxy resin compositions) and their cured products, obtained in the following Examples and Comparative Examples, are as follows.

### [Epoxy resin composition]

### <Epoxy equivalent>

The epoxy equivalent was defined as "mass of an epoxy resin including 1 equivalent of an epoxy group" and was measured according to JIS K7236.

### <Compositional ratio of epoxy resin composition>

The proportion of each of epoxy resins (3-1), (4-1), and (5-1) contained in the epoxy resin composition was calculated as the proportion (% by mass) by performing LC analysis with the following apparatus and conditions, based on JIS K0124, and dividing each area (% by area) in an LC chart, of the epoxy resin (3-1), the epoxy resins (4-1) and (5-1), and other component, by the total (% by area) of the epoxy resin (3-1), the epoxy resins (4-1) and (5-1), and other component.
Apparatus: high-performance liquid chromatography Waters 2690 manufactured by Waters Corporation
Column: TSKgel ODS-120A (column dimension 4.6 mm I.D. × 15 cm) manufactured by Tosoh Corporation
Eluent: flow rate in gradient analysis: 1 mL/min, acetonitrile/water = 30/70 to 100/0 over 60 minutes
Detector: UV (280 nm)
Temperature: 35°C
Concentration of sample: 0.1%
Amount of injection: 10 µL
Analysis software of peak area: Empower 2 manufactured by Waters Corporation

### <Amount of hydrolyzable chlorine>

The amount was quantitatively determined by dissolving 0.5 g of the epoxy resin in 20 mL of dioxane, and performing reflux in 5 mL of a 1 N KOH/ethanol solution for 30 minutes and then titration with a 0.01 N silver nitrate solution.

### <Melting point>

Measurement was made with a differential scanning calorimeter (manufactured). The temperature at an exothermic peak top in temperature rise of 5 mg of a sample at 10°C/min was adopted as the melting point.

### <Crystallization time>

Twenty g of the epoxy resin composition was weighed on an aluminum dish, and heated and melted in a safe ben dryer (manufactured) at 130°C for 1 hour. The dish was taken out from the safe ben dryer, and the time until crystal precipitation at three locations after placement at room temperature was confirmed and defined as the crystallization time.

### [Cured product]

### <Glass transition temperature Tg (tanδ) and storage elastic modulus E' (250°C)>

A test piece obtained by cutting the cured product to a size of a length of 5 cm, a width of 1 cm, and a thickness of 4 mm was used to perform dynamic viscoelasticity measurement (DMA: Dynamic Mechanical Analysis) in the following conditions, thereby measuring the Tg (tanδ) and the storage elastic modulus (E') at 250°C.
Analysis apparatus: EXSTAR6100 manufactured by Seiko Instruments Inc.
Measurement mode: three-point bending mode
Measurement temperature range: 30°C to 280°C
Rate of temperature rise: 5°C/min
Rate of temperature drop: 5°C/min
* the temperature at a peak top of tanδ was defined as Tg (tan6).

### <Water absorption test>

A test piece obtained by cutting the cured product to a size of a length of 2 cm, a width of 2 cm, and a thickness of 4 mm was produced, and left to still stand in a constant temperature and humidity apparatus (NAGANO SCIENCE Co., Ltd. "LH21-11P") under an atmosphere at 85°C/85% RH for 24 hours, and then the water absorption percentage of the cured product was calculated from the respective masses of the test piece before and after water absorption, according to the following formula. Water absorption percentage (%) = {(Mass of test piece after water supply - Mass of test piece before water supply)/(Mass of test piece before water supply)} × 100

### [Production and evaluation of epoxy resin (epoxy resin composition (A))]

### [Example 1]

A four-necked flask having an inner volume of 5 L, equipped with a thermometer, a stirring apparatus, and a condenser tube, was loaded with 200 g of raw material phenol (2-1): tetramethylbiphenol (manufactured by Mitsubishi Chemical Corporation), 1071 g of epichlorohydrin, 5.4 g of a compound (1-1), 417 g of isopropyl alcohol, and 150 g of water, the temperature was raised to 40°C for uniform dissolution, and then 159 g of an aqueous 48.5% by mass sodium hydroxide solution was dropped over 90 minutes. The temperature was raised from 40°C to 65°C over 90 minutes, at the same time as the dropping. Thereafter, the resultant was retained at 65°C for 30 minutes to complete the reaction, the reaction liquid was transferred to a 5-L separating funnel, 300 g of warm water at 65°C was added and cooled to 65°C, and left to still stand for 1 hour. After still standing, an aqueous layer was extracted from an oil layer and the aqueous layer which were separated, and a by-product salt and excess sodium hydroxide were removed. Thereafter, epichlorohydrin was completely removed at 150°C under reduced pressure.

Thereafter, 439 g of methyl isobutyl ketone was loaded, the temperature was raised to 65°C for uniform dissolution, then 6.2 g of an aqueous 48.5% by mass sodium hydroxide solution was loaded, the reaction was performed for 60 minutes, and then washing with 400 g of water was performed four times. Thereafter, methyl isobutyl ketone was completely removed at 150°C under reduced pressure to obtain an epoxy resin composition of Example 1. The epoxy equivalent (g/eq) and the contents (%) of the epoxy resins (3-1), (4-1) and (5-1) were calculated, and the amount of hydrolyzable chlorine (ppm by mass), the melting point (°C) and the crystallization rate (sec) were measured by the following methods.

The results are shown in Table 1.

### [Example 2]

An epoxy resin composition of Example 2 was obtained in the same manner as in Example 1 except that the amount of the compound (1-1) loaded was changed to 10.7 g, and the epoxy equivalent (g/eq) and the contents (%) of the epoxy resins (3-1), (4-1) and (5-1) were calculated and the amount of hydrolyzable chlorine (ppm by mass), the melting point (°C) and the crystallization rate (sec) were measured in the same manner.

The results are shown in Table 1.

### [Example 3]

An epoxy resin composition of Example 3 was obtained in the same manner as in Example 1 except that the amount of the compound (1-1) loaded was changed to 21.4 g, and the epoxy equivalent (g/eq) and the contents (%) of the epoxy resins (3-1), (4-1) and (5-1) were calculated and the amount of hydrolyzable chlorine (ppm by mass), the melting point (°C) and the crystallization rate (sec) were measured in the same manner.

The results are shown in Table 1.

### [Example 4]

An epoxy resin composition of Example 4 was obtained in the same manner as in Example 1 except that the amount of the compound (1-1) loaded was changed to 36.4 g, and the epoxy equivalent (g/eq) and the contents (%) of the epoxy resins (3-1), (4-1) and (5-1) were calculated and the amount of hydrolyzable chlorine (ppm by mass), the melting point (°C) and the crystallization rate (sec) were measured in the same manner.

The results are shown in Table 1.

### [Example 5]

An epoxy resin composition of Example 5 was obtained in the same manner as in Example 1 except that the amount of the compound (1-1) loaded was changed to 53.5 g, and the epoxy equivalent (g/eq) and the contents (%) of the epoxy resins (3-1), (4-1) and (5-1) were calculated and the amount of hydrolyzable chlorine (ppm by mass), the melting point (°C) and the crystallization rate (sec) were measured in the same manner.

The results are shown in Table 1.

### [Example 6]

An epoxy resin composition of Example 6 was obtained in the same manner as in Example 1 except that the amount of the compound (1-1) loaded was changed to 107 g, and the epoxy equivalent (g/eq) and the contents (%) of the epoxy resins (3-1), (4-1) and (5-1) were calculated and the amount of hydrolyzable chlorine (ppm by mass), the melting point (°C) and the crystallization rate (sec) were measured in the same manner.

The results are shown in Table 1.

### [Example 7]

An epoxy resin composition of Example 7 was obtained in the same manner as in Example 1 except that the amount of epichlorohydrin loaded was changed to 765 g, the amount of the compound (1-1) loaded was changed to 15.3 g, the amount of isopropyl alcohol loaded was changed to 297 g, and the amount of water was changed to 0 g, and the epoxy equivalent (g/eq) and the contents (%) of the epoxy resins (3-1), (4-1) and (5-1) were calculated and the amount of hydrolyzable chlorine (ppm by mass), the melting point (°C) and the crystallization rate (sec) were measured in the same manner by the following methods.

The results are shown in Table 1.

### [Comparative Example 1]

An epoxy resin composition of Comparative Example 1 was obtained in the same manner as in Example 1 except that no compound (1-1) was used, and the epoxy equivalent (g/eq) and the contents (%) of the epoxy resins (3-1), (4-1) and (5-1) were calculated and the amount of hydrolyzable chlorine (ppm by mass), the melting point (°C) and the crystallization rate (sec) were measured in the same manner.

The results are shown in Table 1.

### [Comparative Example 2]

An epoxy resin composition of Comparative Example 2 was obtained in the same manner as in Example 7 except that no compound (1-1) was used, and the epoxy equivalent (g/eq) and the contents (%) of the epoxy resins (3-1), (4-1) and (5-1) were calculated and the amount of hydrolyzable chlorine (ppm by mass), the melting point (°C) and the crystallization rate (sec) were measured in the same manner.

The results are shown in Table 1.

### [Comparative Example 3]

An epoxy resin composition was obtained by the same operation as in Comparative Example 1. Thereafter, an epoxy resin composition of Comparative Example 3 was obtained by subj ecting the epoxy resin composition obtained to a crystallization operation in propylene glycol monomethyl ether three times, and distilling off the solvent contained, under reduced pressure, and the epoxy equivalent (g/eq) and the contents (%) of the epoxy resins (3-1), (4-1) and (5-1) were calculated and the amount of hydrolyzable chlorine (ppm by mass), the melting point (°C) and the crystallization rate (sec) were measured in the same manner.

The results are shown in Table 1.

### [Table 1]

**Table 1**

| | | | Example | | | | | | | Comparative Example | | |
|---|---|---|---|---|---|---|---|---|---|---|---|---|
| | | | 1 | 2 | 3 | 4 | 5 | 6 | 7 | 1 | 2 | 3 |
| Production conditi ons | Tetramethylbiphenol | g | 200 | 200 | 200 | 200 | 200 | 200 | 200 | 200 | 200 | Produced by recrystallization |
| | Epichlorohydrin | g | 1071 | 1071 | 1071 | 1071 | 1071 | 1071 | 765 | 1071 | 765 | |
| | Isopropyl alcohol | g | 417 | 417 | 417 | 417 | 417 | 417 | 297 | 417 | 297 | |
| | Water | g | 150 | 150 | 150 | 150 | 150 | 150 | 0 | 150 | 0 | |
| | Compound (1-1) | g | 5.4 | 107 | 21.4 | 36.4 | 53.5 | 107 | 15.3 | 0 | 0 | |
| | Proportion of compound (1-1) to epichlorohydrin | % by mass | 0.5 | 1.0 | 20 | 3.4 | 5.0 | 100 | 20 | 0 | 0 | |
| Results | Epoxy equivalent | g/eq | 184 | 184 | 187 | 186 | 186 | 190 | 186 | 184 | 185 | 177 |
| | Content of epoxy resin (3-1) | % by mass | 92.3 | 901 | 89.6 | 88.5 | 90.5 | 88.1 | 90.0 | 91.9 | 89.7 | 99.9 |
| | Contents of epoxy resins (4-1) and (5-1) | % by mass | 0.34 | 0.54 | 0.99 | 1.65 | 2.43 | 4.69 | 1.18 | 0.07 | 0.05 | 0 |
| | Amount of hydrolyzable chlorine | ppm by mass | 200 | 305 | 279 | 381 | 207 | 227 | 191 | 242 | 188 | 10 |
| | Melting point | °C | 107 | 105 | 105 | 106 | 106 | 106 | 106 | 110 | 109 | 115 |
| | Crystallization time | see | 330 | 630 | 690 | 780 | 540 | 900 | 720 | 420 | 460 | 150 |

### [Production and evaluation of cured product]

### [Examples 8 to 12 and Comparative Examples 4 and 5]

Each of the epoxy resin compositions of Examples 1 to 5 and Comparative Examples 1 and 3, a curing agent (phenol novolac resin (trade name "PSM4261" manufactured by GUN EI Chemical Industry)) and a curing catalyst (triphenylphosphine (trade name "HOKKO TPP" manufactured by HOKKO CHEMICAL INDUSTRY CO., LTD.)) were blended at a ratio shown in Table 2, warmed to 100°C and stirred until a homogeneous system was obtained, and thus each epoxy resin composition was obtained. The epoxy resin composition obtained was heated at 120°C for 2 hours and at 175°C for 6 hours and thus cured to obtain a cured product.

The cured product obtained was subjected to measurement of the Tg and the storage elastic modulus and the water absorption test, and the results were shown in Table 2. In Table 2, "part(s)" represents "part(s) by mass".

### [Table 2]

**Table 2**

| | | | Example | | | | | Comparative Example | |
|---|---|---|---|---|---|---|---|---|---|
| | | | 8 | 9 | 10 | 11 | 12 | 4 | 5 |
| Epoxy resin composition | Epoxy resin of Example 1 | part(s) | 100 | | | | | | |
| | Epoxy resin of Example 2 | part(s) | | 100 | | | | | |
| | Epoxy resin of Example 3 | part(s) | | | 100 | | | | |
| | Epoxy resin of Example 4 | part(s) | | | | 100 | | | |
| | Epoxy resin of Example 5 | part(s) | | | | | 100 | | |
| | Epoxy resin of Comparative Example 1 | part(s) | | | | | | 100 | |
| | Epoxy resin of Comparative Example 3 | part(s) | | | | | | | 100 |
| | Curing agent | part(s) | 57 | 57 | 56 | 56 | 56 | 57 | 59 |
| | Curing accelerator | part(s) | 1 | 1 | 1 | 1 | 1 | 1 | 1 |
| Results | Glass transition temperature | °C | 152 | 146 | 149 | 149 | 148 | 152 | 155 |
| | Storage elastic modulus | MPa | 14 | 21 | 15 | 20 | 23 | 21 | 24 |
| | Water absorption percentage | % | 0.87 | 0.73 | 0.89 | 0.81 | 0.82 | 0.92 | 0.91 |

### [Evaluation of results]

It was found from the results in Examples 1 to 7 that the content of the epoxy resin (4) or (5) in the epoxy resin composition could be controlled by the amount of the compound (1) (compound (6)) relative to epichlorohydrin in reaction. The content of the compound (1) (compound (6)) in reaction can be controlled and thus an epoxy resin having the property of flowing at a low temperature can be obtained.

It was also found from the results in Examples 8 to 12 that the content of the epoxy resin (4) or (5) in the epoxy resin composition was in a controlled range to allow a cured product thereof to have the properties of a low storage elastic modulus and a low water absorption percentage.

It can be seen from these results that an epoxy resin composition including a predetermined proportion of the epoxy resin (4) or (5) has a high production efficiency in epoxy resin composition production, has a low load on the environment in semiconductor manufacturing, and can serve as a raw material of an electronic material high in reliability from the viewpoint heat-resistant durability and mechanical properties, and water absorption properties.

## Claims

1. A method for producing an epoxy resin, comprising reacting a raw material phenol compound or a raw material amine compound and epihalohydrin, wherein said reaction is performed in the presence of a compound represented by the following formula (1): 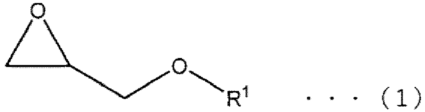 in the formula (1), R¹ represents an aliphatic hydrocarbon group having 2 to 8 carbon atoms.

2. The method for producing an epoxy resin according to claim 1, wherein an amount of the compound represented by the formula (1) is 0.01 to 19% by mass relative to the epihalohydrin.

3. The method for producing an epoxy resin according to claim 1 or 2, wherein the raw material phenol compound is represented by the following formula (2), and the epoxy resin comprises an epoxy compound represented by the following formula (3): 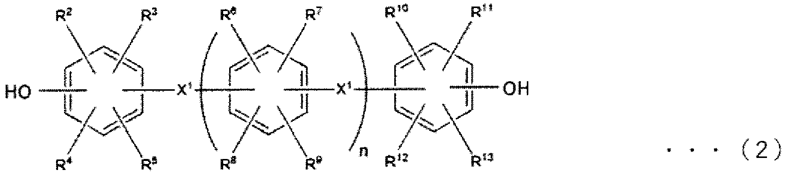 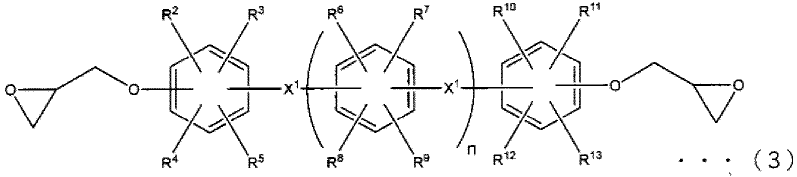 in the formulae (2) and (3), X¹ is a group selected from the group consisting of a divalent hydrocarbon group having 1 to 13 carbon atoms, -O-, -S-, -SO₂-, -C(CF₃)₂- and -CO-, or a direct bond, R² to R¹³ are each independently a hydrogen atom, an alkyl group having 1 to 12 carbon atoms, an alkoxy group having 1 to 12 carbon atoms, an aryl group having 6 to 12 carbon atoms, an alkenyl group having 2 to 12 carbon atoms or an alkynyl group having 2 to 12 carbon atoms, and n represents an integer of 0 to 10.

4. The method for producing an epoxy resin according to any one of claims 1 to 3, wherein the epoxy resin comprises an epoxy compound represented by the following formula (4): 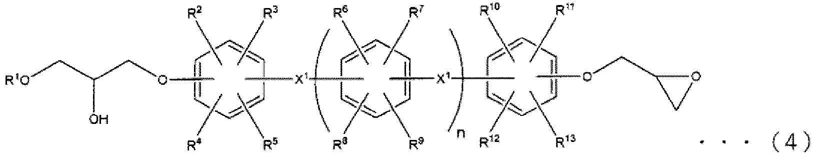 in the formula (4), X¹, R² to R¹³, and n have the same meanings as those in the formula (2) and the formula (3), and R¹ has the same meaning as that in the formula (1).

5. An epoxy resin composition (A) comprising 80.0 to 99.9% by mass of an epoxy compound represented by the following formula (3) and comprising 0.1 to 8.0% by mass of an epoxy compound represented by the following formula (5): 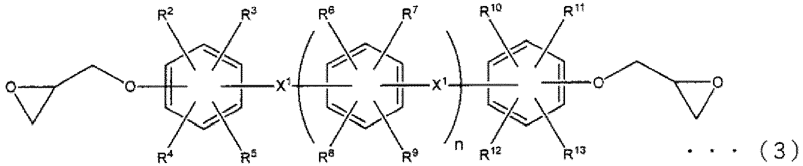 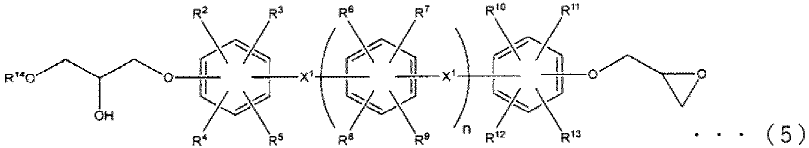 in the formulae (3) and (5), X¹ is a group selected from the group consisting of a divalent hydrocarbon group having 1 to 13 carbon atoms, -O-, -S-, -SO₂-, -C(CF₃)₂- and -CO-, or a direct bond, R² to R¹³ are each independently a hydrogen atom, an alkyl group having 1 to 12 carbon atoms, an alkoxy group having 1 to 12 carbon atoms, an aryl group having 6 to 12 carbon atoms, an alkenyl group having 2 to 12 carbon atoms or an alkynyl group having 2 to 12 carbon atoms, n represents an integer of 0 to 10, and R¹⁴ is a non-linear aliphatic hydrocarbon group having 3 to 8 carbon atoms.

6. The epoxy resin composition (A) according to claim 5, wherein an amount of hydrolyzable chlorine is 1000 ppm by mass or less.

7. An epoxy resin composition (B) comprising the epoxy resin composition (A) according to claim 5 or 6 and comprising 0.01 to 1000 parts by mass of a curing agent based on 100 parts by mass of the epoxy resin composition (A).

8. The epoxy resin composition (B) according to claim 7, wherein the curing agent is at least one selected from the group consisting of a phenol-based curing agent, an amine-based curing agent, an acid anhydride-based curing agent, and an amide-based curing agent.

9. A cured product obtainable by curing the epoxy resin composition (B) according to claim 7 or 8.

10. An electric/electronic component obtained by curing the epoxy resin composition (B) according to claim 7 or 8.
